(19) Europäisches Patentamt
European Patent Office
Office européen des brevets

(11) **EP 3 184 673 B1**

(12) **FASCICULE DE BREVET EUROPEEN**

(45) Date de publication et mention de la délivrance du brevet:
**23.01.2019 Bulletin 2019/04**

(51) Int Cl.:
***C30B 33/02*** [(2006.01)]

(21) Numéro de dépôt: **16204250.1**

(22) Date de dépôt: **15.12.2016**

(54) **PROCÉDÉ D'ÉTALONNAGE D'UN FOUR DE RECUIT UTILISÉ POUR FORMER DES DONNEURS THERMIQUES**

VERFAHREN ZUM EINSTELLEN EINES BRENNOFENS, DER FÜR DAS FORMEN VON WÄRMESPENDERN VERWENDET WIRD

METHOD FOR CALIBRATING AN ANNEALING FURNACE USED TO FORM HEAT DONORS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.12.2015 FR 1562979**

(43) Date de publication de la demande:
**28.06.2017 Bulletin 2017/26**

(73) Titulaire: **COMMISSARIAT À L'ÉNERGIE ATOMIQUE ET AUX ÉNERGIES ALTERNATIVES**
**75015 Paris (FR)**

(72) Inventeurs:
• **DUBOIS, Sébastien**
**74950 SCIONZIER (FR)**
• **VEIRMAN, Jordi**
**74330 POISY (FR)**

(74) Mandataire: **Cabinet Camus Lebkiri**
**25 rue de Maubeuge**
**75009 Paris (FR)**

(56) Documents cités:
**FR-A1- 2 997 096 US-A1- 2009 261 299**

• **W. WIJARANAKULA: "Formation kinetics of oxygen thermal donors in silicon", APPLIED PHYSICS LETTERS, vol. 59, no. 13, 1 janvier 1991 (1991-01-01), page 1608, XP055114038, ISSN: 0003-6951, DOI: 10.1063/1.106245**
• **LONDOS C A ET AL: "Effect of oxygen concentration on the kinetics of thermal donor formation in silicon at temperatures between 350 and 500 DEG C", APPLIED PHYSICS LETTERS, A I P PUBLISHING LLC, US, vol. 62, 29 mars 1993 (1993-03-29), pages 1525-1526, XP002402566, ISSN: 0003-6951, DOI: 10.1063/1.108628**

**Description**

**DOMAINE TECHNIQUE**

La présente invention est relative à la fabrication de plaquettes à partir d'un lingot en matériau semi-conducteur. L'invention concerne plus particulièrement un procédé d'étalonnage d'un four de recuit utilisé pour créer des donneurs thermiques dans un échantillon de matériau semi-conducteur, tel qu'un tronçon de lingot ou une brique découpée dans le lingot.

**ÉTAT DE LA TECHNIQUE**

Les plaquettes de silicium utilisées pour la fabrication de cellules photovoltaïques à haut rendement sont généralement issues de lingots en silicium monocristallin obtenus par le procédé de tirage Czochralski (Cz). Ces plaquettes sont préférentiellement dopées de type n, en introduisant des atomes de phosphore donneurs d'électrons dans le silicium. Le dopage de type n au phosphore (P) est préféré au dopage de type p au bore (B), en raison notamment de l'absence de complexes bore-oxygène qui diminuent la durée de vie des porteurs de charge dans le silicium.

Le phosphore est incorporé au silicium avant le tirage du lingot, lorsque le silicium est à l'état fondu, en versant dans le bain de silicium fondu une poudre de phosphore ou des plaquettes de silicium fortement dopées en phosphore. Cette technique de dopage présente des inconvénients, parmi lesquels figure la contamination du silicium. En effet, la poudre de phosphore ou les plaquettes de silicium versées dans le bain contiennent également des métaux et du carbone. Ces impuretés s'incorporent au silicium en même temps que le phosphore, ce qui entraine une contamination du silicium, d'abord au niveau du bain, puis au niveau du lingot. En outre, étant donné que le coefficient de ségrégation du phosphore est faible (environ 0,35), une variation significative de la concentration en phosphore, et donc de la résistivité électrique, apparaît sur la hauteur du lingot. Or les performances des cellules photovoltaïques sont dépendantes de la résistivité électrique. Les cellules photovoltaïques obtenues à partir du lingot n'auront donc pas les mêmes performances, et notamment le même rendement de conversion photovoltaïque. Ainsi, une portion du lingot risque d'être inutilisable, ce qui représente une perte financière pour le fournisseur de plaquettes.

Pour éviter ces inconvénients, une autre technique de dopage faisant intervenir les donneurs thermiques a été développée. Elle est décrite dans l'article [« High Quality Thermal Donor Doped Czochralski Silicon Ingot for Industrial Heterojunction Solar Cells », F. Jay et al., EU PVSEC Proceedings 2015, pp. 316-321]. Les donneurs thermiques sont des agglomérats créés à partir de l'oxygène interstitiel contenu dans le silicium (i.e. les atomes d'oxygène occupent des positions interstitielles dans le réseau cristallin), lorsqu'il est soumis à une température comprise entre 350 °C et 550 °C. Chaque donneur thermique génère deux électrons libres, ce qui engendre une variation de la résistivité électrique du silicium.

Cette technique de dopage permet l'obtention de plaquettes de résistivité quasiment identique et ne contenant que très peu d'impuretés. Tout d'abord, un lingot en silicium monocristallin est cristallisé à partir d'un bain de silicium fondu, au moyen du procédé Czochralski. Le silicium utilisé pour préparer le bain est intrinsèque et aucun dopant n'a été volontairement introduit dans le bain. Dans ces conditions, la résistivité du lingot ne dépend que de la concentration en donneurs thermiques. La concentration en oxygène interstitiel et la concentration initiale en donneurs thermiques, formés lors de la cristallisation, sont ensuite mesurées sur la hauteur du lingot. Il peut alors être calculé, pour chaque hauteur du lingot, une concentration de donneurs thermiques supplémentaires à créer pour atteindre une résistivité cible. Ces donneurs thermiques supplémentaires sont formés lors d'un recuit à 450 °C. Pour chaque hauteur du lingot, la durée de recuit nécessaire à l'obtention des donneurs thermiques supplémentaires est calculée, connaissant la concentration en oxygène interstitiel. Le lingot est ensuite découpé en tronçons. A chaque tronçon correspond une durée de recuit, car les durées de recuit calculées sont sensiblement identiques dans un même tronçon. Enfin, chaque tronçon de lingot est soumis au recuit à 450 °C pendant la durée correspondante, avant d'être découpé en plaquettes.

L'étape la plus critique de ce procédé de fabrication de plaquettes est le recuit à 450 °C des différents tronçons de lingot. Il faut en effet éviter les variations brutales de température lorsqu'un tronçon est introduit dans le four de recuit, puis sorti du four, car le tronçon peut se briser. Il convient par conséquent d'augmenter progressivement la température après avoir introduit le tronçon dans le four, et de la diminuer tout aussi progressivement avant d'extraire le tronçon du four. Le problème est qu'il est alors difficile de connaître la durée exacte de formation des donneurs thermiques. En effet, des donneurs thermiques sont également formés pendant la phase de chauffe (de 350 °C à 450 °C) et la phase de refroidissement (de 450 °C à 350°C) du four. La quantité de donneurs thermiques supplémentaires formés lors du recuit diffère alors de celle calculée à partir de la résistivité cible et la résistivité cible n'est finalement pas atteinte.

**RÉSUMÉ DE L'INVENTION**

Il existe donc un besoin de prévoir un procédé d'étalonnage d'un four, permettant de contrôler de façon précise la formation des donneurs thermiques lorsqu'un échantillon de matériau semi-conducteur est soumis dans ce four à un premier recuit, le premier recuit comprenant successivement une montée en température du four, un premier palier à une température de consigne et une descente en température du four.

Selon l'invention, on tend à satisfaire ce besoin en prévoyant les étapes suivantes :

a) prévoir une pièce étalon constituée du matériau semi-conducteur ;
b) déterminer la concentration en oxygène interstitiel de la pièce étalon ;
c) soumettre la pièce étalon à un deuxième recuit de formation des donneurs thermiques dans le four, le deuxième recuit comprenant des montée et descente en température du four identiques à celles du premier recuit et un deuxième palier à la température de consigne pendant une durée de consigne ;
d) déterminer la concentration en donneurs thermiques formés dans la pièce étalon lors du deuxième recuit ; et
e) déterminer une durée équivalente de recuit à la température de consigne, correspondant au moins auxdites montée et descente en température du four, à partir de la concentration en oxygène interstitiel, de la concentration en donneurs thermiques de la pièce étalon et de la durée de consigne.

En d'autres termes, ce procédé d'étalonnage permet de déterminer la durée de recuit à la température de consigne, par exemple 450 °C, qui correspond au moins en partie aux phases de chauffe et de refroidissement du four. La connaissance d'une telle information est précieuse, en particulier dans le cadre du procédé de fabrication de plaquettes décrit précédemment. En effet, on peut ainsi tenir compte des donneurs thermiques formés lors des phases de chauffe et de refroidissement du four, lorsqu'on paramètre le four pour réaliser le recuit des tronçons de lingot. La quantité de donneurs thermiques supplémentaires formés par le recuit se rapproche alors davantage de celle calculée à partir de la résistivité cible. Le procédé d'étalonnage permet donc de rendre plus précis l'ajustement de la résistivité électrique par les donneurs thermiques.

Le deuxième palier de température, entre la montée et la descente en température du deuxième recuit, laisse plus de temps à la pièce étalon pour atteindre la température de consigne. Ainsi, la montée et la descente en température de la pièce étalon correspondent à celles que subit l'échantillon lors du premier recuit (le premier recuit comprend le premier palier à la température de consigne).

Ce deuxième palier permet en outre de prendre en compte les écarts entre la température de l'échantillon et la température de consigne dans la détermination de la durée équivalente de recuit, et donc les éventuels phénomènes d'instabilité de la température du four qui sont répercutés sur l'échantillon.

Avantageusement, la pièce étalon présente une géométrie et des dimensions identiques à celles de l'échantillon. La précision de l'étalonnage est ainsi améliorée, car la pièce étalon et l'échantillon subiront précisément les mêmes montée et descente en température.

La durée de consigne est avantageusement comprise entre 30 secondes et 2 heures.

Dans un mode de mise en oeuvre préférentiel, les étapes a)-e) sont mises en oeuvre pour une pluralité de pièces étalon ayant des valeurs différentes de durée de consigne, d'où il résulte une pluralité de valeurs de durée équivalente, et le procédé d'étalonnage comprend en outre une étape de détermination de la valeur de durée de consigne au-delà de laquelle la durée équivalente est indépendante de la durée de consigne.

La pièce étalon est avantageusement découpée dans un lingot de matériau semi-conducteur cristallisé selon la méthode Czochralski, et de préférence, dans une partie du lingot cristallisée en dernier.

La concentration en oxygène interstitiel de la pièce étalon peut alors être déterminée en mesurant la concentration en oxygène interstitiel sur au moins une chute issue de la découpe du lingot, ladite chute étant adjacente à la pièce étalon dans le lingot.

La concentration en donneurs thermiques peut être déterminée à partir d'une première mesure de la résistivité électrique ou de la concentration en porteurs de charge libres, réalisée avant le deuxième recuit sur une première plaquette adjacente à la pièce étalon dans le lingot, et d'une deuxième mesure de la résistivité électrique ou de la concentration en porteurs de charge libres, réalisée après le deuxième recuit sur une deuxième plaquette prélevée dans la pièce étalon.

De préférence, le lingot de matériau semi-conducteur est obtenu à partir d'un bain de matériau semi-conducteur intrinsèque en fusion.

## BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :

- la figure 1 représente des profils de la température d'un four et de la température d'un échantillon semi-conducteur placé dans le four, lors d'un recuit de formation des donneurs thermiques ;

- la figure 2 représente un autre profil, équivalent à celui représenté sur la figure 1, de la température de l'échantillon lors du recuit ;
- la figure 3 représente des étapes d'un procédé d'étalonnage selon l'invention ;
- la figure 4 illustre une manière d'obtenir une pièce étalon pour la mise en oeuvre du procédé d'étalonnage selon l'invention ;
- les figures 5 et 6 montrent respectivement un dépassement des températures de l'échantillon et du four au cours du recuit (par rapport à la température de consigne) et de quelle manière ce dépassement peut être entièrement pris en considération dans le procédé d'étalonnage de l'invention ;
- la figure 7 illustre la concentration en donneurs thermiques formés lors de la cristallisation d'un lingot en silicium de type Cz, en fonction de la fraction solidifiée du lingot ;
- la figure 8A représente l'étape de mesure de la résistivité électrique ou de la concentration en porteurs de charge libres, qui précède le recuit de formation des donneurs thermiques de la pièce étalon ; et
- la figure 8B représente l'étape de mesure de la résistivité électrique ou de la concentration en porteurs de charge libres, qui suit le recuit de formation des donneurs thermiques de la pièce étalon.

Pour plus de clarté, les éléments identiques ou similaires sont repérés par des signes de référence identiques sur l'ensemble des figures.

## DESCRIPTION DÉTAILLÉE D'AU MOINS UN MODE DE RÉALISATION

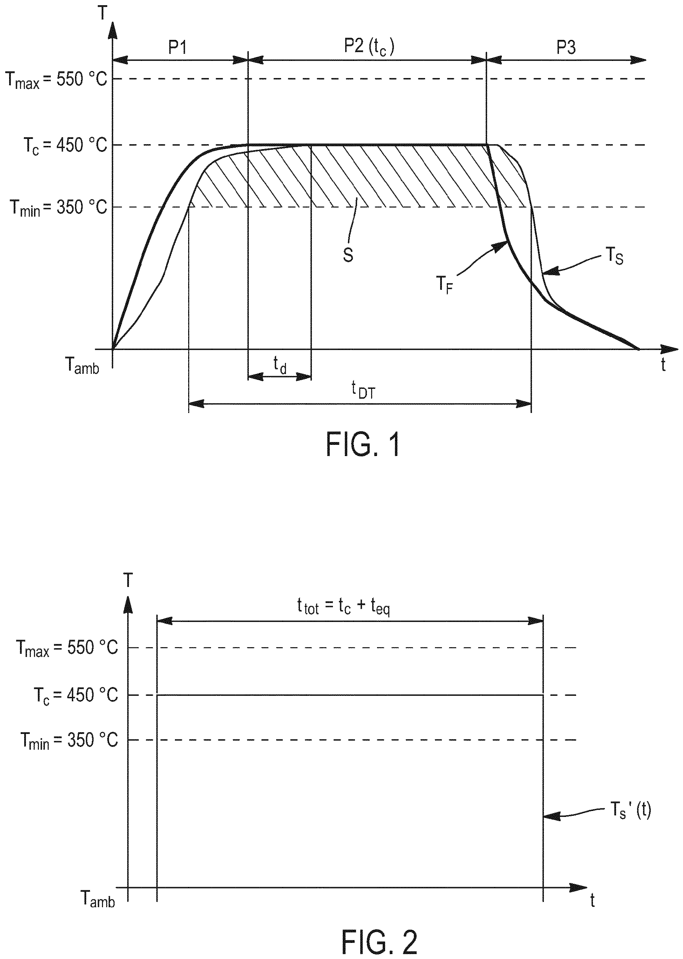

La figure 1 montre un exemple de courbes de la température $T_F$ à l'intérieur d'un four et de la température $T_S$ au sein d'un échantillon en matériau semi-conducteur, lorsque cet échantillon est soumis à un recuit de formation des donneurs thermiques dans le four. L'échantillon peut être un tronçon de lingot ou une brique découpée dans un lingot. La brique a globalement la forme d'un parallélépipède rectangle et permet l'obtention de plaquettes carrées ou pseudo-carrées, qui serviront ensuite à fabriquer des cellules photovoltaïques. Le tronçon de lingot, de forme cylindrique, est plutôt destiné à l'industrie microélectrique, où les plaquettes sont de forme circulaire.

Le recuit de l'échantillon comprend une phase de chauffe P1 dans laquelle la température $T_F$ du four augmente, passant de la température ambiante $T_{amb}$ (par exemple 25 °C) à une température de consigne $T_c$. Dans l'exemple de la figure 1, la température de consigne $T_C$ vaut 450 °C. La phase de chauffe P1 est suivie d'un palier P2 à la température de consigne $T_C$ pendant une durée de consigne $t_c$. La durée de consigne $t_c$ est le temps de recuit, spécifié lors de la programmation du four, pendant lequel le four est censé être à la température de consigne $T_C$ (450°C). Ce temps de recuit est chronométré à partir du moment où la température $T_F$ du four, mesurée par exemple par un thermocouple, atteint 450°C. Lorsqu'il s'arrête, la température $T_F$ du four commence à diminuer. En effet, le palier de température P2 est suivi d'une phase de refroidissement P3, dans laquelle la température $T_F$ passe de 450 °C à la température ambiante $T_{amb}$.

Comme cela est visible sur la figure 1, la température $T_S$ de l'échantillon disposé dans le four n'est pas toujours égale à la température $T_F$ à l'intérieur du four. Pendant les phases de chauffe P1 et de refroidissement P3 notamment, la courbe de température de l'échantillon est en retard par rapport à la courbe de température du four, à cause de l'inertie thermique de l'échantillon. Ce retard est symbolisé sur la figure 1 par une durée « $t_d$ », pendant laquelle la température $T_F$ du four est égale à 450 °C alors que la température $T_S$ de l'échantillon est inférieure à 450°C.

Des donneurs thermiques sont formés dans l'échantillon lorsque sa température $T_S$ est comprise entre $T_{min}$ = 350 °C et $T_{max}$ = 550°C. Compte tenu que la température $T_S$ de l'échantillon n'excède pas 450 °C dans l'exemple de la figure 1, les donneurs thermiques sont ici formés uniquement dans la plage de températures 350 °C-450 °C. La quantité de donneurs thermiques créés lors du recuit peut être représentée par l'aire S située sous la courbe de la température $T_S$ et au-dessus de la droite d'équation $T(t)$ = $T_{min}$ = 350 °C. De façon générale, plus l'aire S est grande, plus la quantité de donneurs thermiques créés est importante (elle augmente avec la température et la durée de recuit).

On constate alors qu'une partie de ces donneurs thermiques est formée lors des phases de chauffe P1 et de refroidissement P3 du four. La durée $t_{DT}$ pendant laquelle la température $T_S$ de l'échantillon est comprise entre 350 °C et 450 °C, autrement dit la durée effective de formation des donneurs thermiques, est supérieure à la durée de consigne $t_c$. Il existe par conséquent une différence entre la quantité de donneurs thermiques formés pendant la durée de consigne $t_c$ (spécifiée par l'opérateur lors de la programmation du four) et la quantité de donneurs thermiques formés par le recuit dans son ensemble.

En outre, pendant le retard $t_d$ (palier P2), la cinétique de formation des donneurs thermiques n'est pas celle escomptée, puisque la température $T_S$ de l'échantillon n'a pas encore atteint la température de consigne $T_C$. Ce retard contribue donc à créer la différence de quantités de donneurs thermiques entre la durée de consigne $t_c$ et le recuit dans son ensemble. Toutefois, cette contribution est en général faible comparée à celle des phases P1 et P3.

Ainsi, lorsqu'on paramètre le four en fixant la durée de consigne $t_c$ du palier P2 à 450 °C, il convient de tenir compte du fait que la formation des donneurs thermiques aura également lieu lors des phases de chauffe P1 et de refroidissement P3 du four et du fait que la température $T_S$ de l'échantillon peut être différente de la température de consigne $T_C$ pendant une partie du palier P2. Cela permet de contrôler plus précisément la quantité de donneurs thermiques formés lors du recuit.

La cinétique de formation des donneurs thermiques lors des phases de chauffe P1 et de refroidissement P3 est difficile à établir, car on ignore le profil $T_S(t)$ exact de la température de l'échantillon. Il n'est donc pas possible de déterminer simplement quelle part des donneurs thermiques est formée lors des phases P1 et P3.

Le procédé d'étalonnage décrit ci-après permet de contourner ces difficultés. Il fait l'hypothèse que la température de l'échantillon lors du recuit est constante et égale à 450 °C, puis détermine la durée de recuit à 450 °C (uniquement), notée ci-après $t_{eq}$, équivalent d'une part aux phases de montée et descente en température et d'autre part aux (éventuels) écarts entre les températures $T_S$ et $T_C$ lors du palier P2.

La figure 2 montre le profil $T_S'(t)$ de la température du tronçon dans une telle hypothèse. Ce profil est équivalent au profil de température $T_S(t)$, variant entre 350 °C et 450 °C et de durée $t_{DT}$, représenté sur la figure 1. Le terme « équivalent » utilisé ci-dessus pour désigner la durée $t_{eq}$ ou le profil de la figure 2 signifie que la quantité de donneurs thermiques formés est la même.

Le profil de température $T_S'(t)$ est en forme de créneau, avec des montée et descente en température instantanées et un plateau à 450 °C d'une durée totale $t_{tot}$ égale à la somme de la durée de consigne $t_c$ et de la durée équivalente $t_{eq}$ :

$$t_{tot} = t_c + t_{eq} \qquad (1)$$

La durée équivalente $t_{eq}$ tient compte, comme indiqué précédent, de la formation des donneurs thermiques lors des phases de montée et descente en température du four et des éventuels écarts de température pendant la durée de consigne $t_c$. Elle varie en fonction du four utilisé, des conditions de chauffe et de refroidissement, de la géométrie et des dimensions du tronçon. Dans certains cas rares, en particulier lorsque la durée de retard $t_d$ est significative, la durée équivalente $t_{eq}$ peut prendre une valeur négative. Autrement dit, la quantité « réelle » de donneurs thermiques formés lors du recuit est inférieure à celle d'un recuit à 450 °C (uniquement) pendant la durée de consigne $t_c$.

La durée totale $t_{tot}$ de recuit à 450 °C est par exemple la durée calculée à partir d'une concentration « cible » en donneurs thermiques (elle-même déduite d'une valeur cible de résistivité) et de la concentration en oxygène interstitiel dans l'échantillon, d'après le procédé d'obtention de plaquettes décrit en introduction.

La connaissance de la durée équivalente $t_{eq}$ de recuit à 450 °C permet alors de déterminer (en utilisant la relation (1) ci-dessus) la valeur exacte de la durée de consigne $t_c$ à programmer pour atteindre la concentration « cible » en donneurs thermiques.

La figure 2 représente des étapes S1 à S5 d'un procédé d'étalonnage du four de recuit permettant de déterminer la durée équivalente $t_{eq}$.

A l'étape S1, on prévoit une pièce étalon constituée du même matériau semi-conducteur que l'échantillon, afin que la cinétique de formation des donneurs thermiques puisse être la même. L'échantillon et la pièce étalon sont par exemple en silicium cristallin. Le silicium monocristallin obtenu par le procédé Czochralski, dit silicium « Cz », est préféré au silicium multicristallin issu d'un procédé de solidification dirigée en creuset, car il présente une concentration plus élevée en oxygène interstitiel. Des donneurs thermiques pourront alors être créés en grande quantité, ce qui améliore la précision de l'étalonnage.

Ainsi, dans un mode de mise en oeuvre du procédé d'étalonnage, la pièce étalon est découpée dans un lingot de silicium Cz, cristallisé à partir d'un bain de silicium fondu. De préférence, la charge de silicium utilisée pour former le bain de silicium fondu est non dopée, c'est-à-dire en silicium intrinsèque, et aucun dopant n'a été rajouté dans le bain. Le silicium du bain est donc intrinsèque au moment du tirage du lingot. Ainsi, la résistivité du matériau sera influencée par les donneurs thermiques uniquement, ce qui améliore la précision de l'étalonnage.

Pour un matériau semi-conducteur autre que ceux obtenus par le procédé Czochralski, la concentration en oxygène interstitiel du matériau semi-conducteur est avantageusement supérieure à $10^{17}$ cm$^{-3}$. Le carbone étant un élément qui limite la formation des donneurs thermiques, sa concentration dans ce matériau semi-conducteur est avantageusement inférieure à $10^{17}$ cm$^{-3}$.

L'étape S2 consiste à déterminer la concentration en oxygène interstitiel [Oi] de la pièce étalon. La concentration en oxygène interstitiel [Oi] peut être mesurée directement sur la pièce étalon, de façon non destructive, par une technique de spectroscopie infrarouge appelée communément « Whole-rod FTIR ». Cette technique, dérivée de la spectroscopie infrarouge à transformée de Fourier (FTIR), consiste à scanner la pièce étalon avec un faisceau infrarouge. L'absorption du faisceau infrarouge par la pièce étalon permet de déterminer une concentration moyenne de l'oxygène interstitiel dans la pièce étalon.

Alternativement, lorsque la pièce étalon a été découpée dans un lingot, la concentration en oxygène interstitiel [Oi] peut être mesurée par FTIR sur une pièce du lingot qui est adjacente à la pièce étalon. Cela permet de préserver la pièce étalon des manipulations nécessaires à la mesure de la concentration [Oi], en particulier du polissage de surface. On peut alors être amené à faire l'hypothèse que la concentration en oxygène interstitiel mesurée sur la pièce adjacente est égale à la concentration en oxygène interstitiel [Oi] de la pièce étalon.

Par exemple, lorsque la pièce étalon est un tronçon de lingot, la concentration [Oi] peut être mesurée par FTIR sur l'une des deux plaquettes, ou tranches, situées de part et d'autre de la pièce étalon, ou sur un morceau seulement de cette plaquette. De préférence, la plaquette (ou le morceau de plaquette) présente une épaisseur supérieure ou égale à 100 $\mu$m et sa surface est polie avant d'effectuer les mesures FTIR.

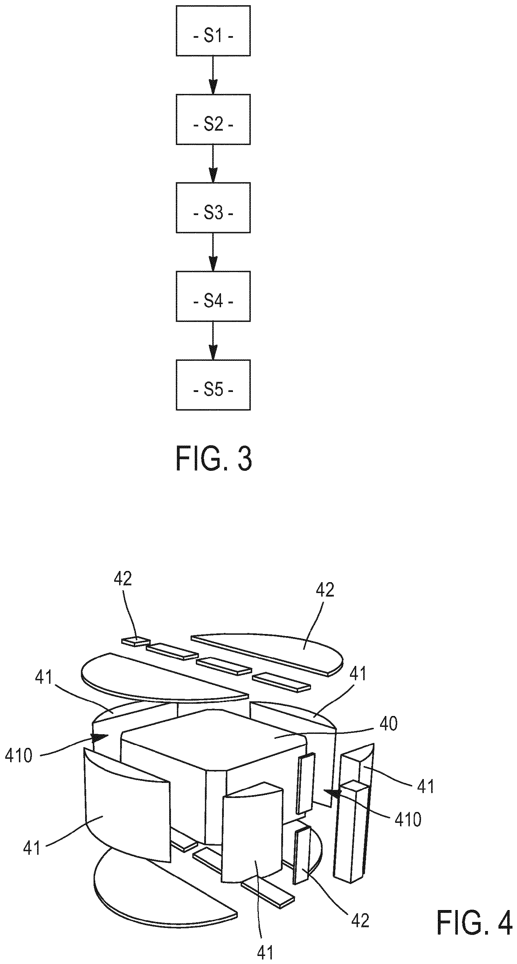

La figure 4 représente le cas où la pièce étalon est une brique 40 découpée dans le lingot. La concentration en oxygène interstitiel [Oi] de la pièce étalon est alors avantageusement mesurée sur l'une quelconque des chutes 41 issues de la découpe du lingot, et de préférence, sur une face intérieure 410 correspondant au plan de coupe. A nouveau, la technique FTIR peut être utilisée (après polissage de la face intérieure).

La figure 4 montre également des morceaux de plaquette 42 situés dans le lingot immédiatement au-dessus, au-dessous et sur les côtés de la pièce étalon. Comme indiqué précédemment, la concentration en oxygène interstitiel [Oi] peut être également mesurée sur l'un quelconque de ces morceaux de plaquette 42. La concentration en oxygène peut aussi être mesurée sur plusieurs morceaux de plaquette 42, par exemple deux situés respectivement au-dessus et en dessous de la pièce étalon, et la concentration [Oi] de la pièce étalon est alors supposée égale à la valeur moyenne des concentrations en oxygène mesurées sur les morceaux 42.

Des techniques autres que la spectroscopie infrarouge (FTIR, Whole-rod FTIR) peuvent être utilisées pour mesurer la concentration en oxygène interstitiel [Oi] de la pièce étalon. En particulier, il peut être fait usage de la technique décrite dans le brevet FR2964459. Cette technique peut être appliquée sur une plaquette de silicium (comme cela est décrit dans le brevet FR2964459), un morceau de plaquette 42, une chute de découpe 41 du lingot ou encore la pièce étalon 40.

A l'étape S3 de la figure 3, la pièce étalon est soumise à un recuit de formation des donneurs thermiques comprenant une montée et une descente en température identiques à celles du recuit de l'échantillon (cf. Fig.1). Les conditions de chauffe et de refroidissement du four sont donc les mêmes entre le recuit de l'échantillon et le recuit de la pièce étalon. La température du four lors du recuit de la pièce étalon atteint la température de consigne $T_C$, fixée ici à 450 °C, puis redescend jusqu'à la température ambiante.

Le recuit S3 de la pièce étalon comprend en outre, à l'instar du recuit de l'échantillon, un palier à la température de consigne $T_C$ entre la montée et la descente en température. La durée de consigne de ce palier est notée ci-après $t_c'$. Un palier lors du recuit S3 permet au procédé d'étalonnage de prendre en compte tous les éventuels écarts entre la température de l'échantillon et la température de consigne $T_C$ pendant la durée de consigne $t_c'$, y compris celui correspondant au retard $t_d$ entre les courbes de température de l'échantillon et du four, car la pièce étalon peut ainsi atteindre plus facilement la température de consigne $T_C$. Ce palier permet notamment de prendre en compte des problèmes de régulation de la température du four au début du palier. La durée $t_{eq}$ (de recuit à 450 °C) est alors équivalente, en termes de quantité de donneurs thermiques formés, aux contributions des phases de montée et descente en température, et des éventuels écarts de température pendant la durée $t_c'$ (y compris le retard $t_d$).

La durée de consigne $t_c'$ du palier à l'étape S3 n'est pas nécessairement égale à la durée de consigne $t_c$ du recuit de l'échantillon. En effet, l'objectif de ce palier est seulement de rapprocher la température de la pièce étalon lors du recuit S3 de la température $T_S$ de l'échantillon, pour affiner au maximum la détermination de la durée équivalente $t_{eq}$.

De préférence, la pièce étalon a la même géométrie et les mêmes dimensions que l'échantillon. La pièce étalon et l'échantillon répondront ainsi de la même manière à la montée et à la descente en température du four (l'inertie thermique étant la même entre les deux pièces). Cela permet d'améliorer significativement la précision de l'étalonnage.

Puis, en S4, la concentration en donneurs thermiques [DT] formés lors du recuit S3 de la pièce étalon est déterminée. Les donneurs thermiques formés lors du recuit S3 peuvent venir s'ajouter aux donneurs thermiques présents initialement dans la pièce étalon et qui ont été générés lors du refroidissement du lingot. La pièce étalon peut aussi être soumise à un recuit préliminaire pour détruire ces donneurs thermiques initiaux, par exemple à 650 °C pendant 30 min.

La concentration [DT] est de préférence obtenue à partir de deux valeurs de la résistivité électrique ou de la concentration en porteurs de charge libres, mesurées respectivement avant et après le recuit S3 de formation des donneurs thermiques. En effet, l'apparition des donneurs thermiques entraîne une variation de la concentration en porteurs de charge libres, et donc de la résistivité électrique. Par « porteurs de charge libres », on entend les porteurs de charge (i.e. électrons ou trous) qui sont libres de circuler dans le matériau semi-conducteur et qui sont responsables de la conductivité électrique du matériau. Leur concentration dépend du niveau de dopage initial du matériau semi-conducteur (de type p ou n), qui a été accentué ou compensé par la formation des donneurs thermiques (défauts « donneurs d'électrons ») en concentration [DT].

Une première mesure de la résistivité - ou de la concentration en porteurs de charge libres - est donc réalisée avant le recuit S3 et une deuxième mesure de la résistivité - ou de la concentration en porteurs de charge libres - est réalisée après le recuit S3. La résistivité électrique peut être mesurée par la méthode des quatre pointes, la méthode de Van der Pauw, par couplage inductif ou être dérivée de la mesure du courant de Foucault. La concentration en porteurs de charge libres peut être mesurée par effet Hall, par photoluminescence, par l'analyse de l'absorption d'un rayonnement infrarouge par les porteurs de charge libres (dite analyse FCA, pour « Free Carrier Absorption » en anglais), ou déduite de mesures C-V.

Les première et seconde mesures sont, dans un mode de mise en oeuvre de l'étape S4, réalisées dans une même région de la surface de la pièce étalon (40). Dans une variante de mise en oeuvre, la première mesure est réalisée sur une plaquette adjacente à la pièce étalon dans le lingot, par exemple celle située immédiatement au-dessus ou au-dessous de la pièce étalon (ou les deux et la valeur moyenne est alors calculée), et la deuxième mesure est réalisée sur une plaquette prélevée en surface de la pièce étalon ou à l'intérieur de la pièce étalon. La même plaquette peut alors servir pour la mesure de résistivité et la détermination de la concentration en oxygène [Oi] (étape S2).

Lorsqu'une mesure de résistivité est effectuée en dehors de la pièce étalon, c'est-à-dire sur une pièce adjacente du lingot, la valeur mesurée de résistivité peut être extrapolée pour déterminer la résistivité de la pièce étalon. Il en est de même pour une mesure de la concentration en porteurs de charge libres en dehors de la pièce étalon.

La concentration en donneurs thermiques [DT] peut être calculée à partir des valeurs mesurées de résistivité électrique (ou de la concentration en porteurs de charge libres) en utilisant les relations usuelles de la résistivité et de la mobilité des porteurs de charge. Il est toutefois préférable, comme indiqué dans le brevet FR2964459, de modifier la relation de la mobilité pour tenir compte de l'influence des donneurs thermiques.

Enfin, à l'étape S5, la durée totale $t_{tot}$ du recuit à $T_C = 450\ °C$, équivalent en termes d'activation des donneurs thermiques au recuit mis en oeuvre à l'étape S3 (montée et descente en température du four, phases d'instabilité de la température, plateau à 450 °C), est déterminée à partir de la concentration en oxygène interstitiel [Oi] et de la concentration en donneurs thermiques [DT] de la pièce étalon, déterminées respectivement aux étapes S2 et S4.

La durée $t_{tot}$ peut être calculée en utilisant une relation tirée de l'article [« Formation kinetics of oxygen thermal donors in silicon », Wijaranakula C.A. et al., Appl. Phys. Lett. 59 (13), pp. 1608, 1991]. Cet article décrit la cinétique de formation des donneurs thermiques dans le silicium par un recuit à 450 °C.

D'après l'article susmentionné, la concentration en donneurs thermiques [DT], la concentration initiale en oxygène interstitiel [Oi] et la durée t de recuit à 450 °C sont liées par la relation suivante :

$$[DT] = 4,51.10^{-52} \times \left( [Oi] \cdot \left( 1 + \frac{2}{3} D_o \times t \times [Oi]^{2/3} \right)^{-3/2} \right)^{3,45} \times t^{1,02} \qquad (2)$$

avec $D_o$ le coefficient de diffusion de l'oxygène interstitiel à 450 °C ($D_o = 3,5.10^{-19}\ cm^2/s$).

En remplaçant les termes [DT] et [Oi] de la relation (2) ci-dessus par les valeurs mesurées aux étapes S2 et S4 respectivement, on obtient une valeur de t égale à la durée totale $t_{tot}$ recherchée.

Pour calculer la durée totale $t_{tot}$, la relation (2) ci-dessus est privilégiée car une température de consigne $T_C$ égale à 450 °C est préférentiellement choisie pour réaliser le recuit des échantillons de lingot, afin d'ajuster leur résistivité. La température de 450 °C est en effet celle à laquelle la cinétique de formation des donneurs thermiques est la mieux maitrisée. En outre, elle constitue un bon compromis entre la vitesse de formation des donneurs thermiques et la concentration maximale obtenue.

Alternativement, la durée $t_{tot}$ peut être déterminée à l'aide d'autres expressions mathématiques ou d'abaques, donnant la concentration en donneurs thermiques [DT] en fonction de la durée t de recuit à 450 °C, pour différentes valeurs de la concentration en oxygène [Oi].

Pour une température de consigne différente de 450°C, les expressions mathématiques et les abaques peuvent être adaptés notamment grâce aux enseignements de l'article [« Effect of oxygen concentration on the kinetics of thermal donor formation in silicon at temperatures between 350 and 500 °C », Londos C.A. et al., Appl. Phys. Lett. 62 (13), pp. 1525, 1993]. Cet article décrit également la cinétique de formation des donneurs thermiques dans le silicium, mais pour des températures de recuit comprises entre 350 °C et 500 °C.

La durée équivalente $t_{eq}$ de recuit à 450°C est ensuite déterminée à partir de la durée totale $t_{tot}$ et de la durée de consigne $t_c'$, en retranchant la durée de consigne $t_c'$ à la durée totale $t_{tot}$ (cf. relation (1)). Alternativement, la détermination de la durée équivalente $t_{eq}$ peut être effectuée en une seule étape de calcul, à partir de la concentration en oxygène [Oi], de la concentration en donneurs thermiques [DT] et de la durée de consigne $t_c'$.

Les étapes S1-S5 du procédé d'étalonnage ne sont pas nécessairement mises en oeuvre dans l'ordre qui vient d'être décrit en relation avec la figure 3. En particulier, l'étape S2 de mesure de la concentration en oxygène [Oi] peut être accomplie après le recuit S3 de la pièce étalon, plutôt qu'avant. En effet, le recuit de formation des donneurs thermiques n'a pratiquement pas d'influence sur la concentration en oxygène interstitiel. La concentration en oxygène [Oi] peut donc être mesurée sur une plaquette prélevée à l'intérieur de la pièce étalon, après que la pièce étalon ait subit le recuit S3. L'étape S2 pourrait également être réalisée après l'étape S4 de détermination de la concentration en donneurs thermiques formés par le recuit S3.

Bien qu'ils soient peu fréquents, des écarts entre la température de l'échantillon et la température de consigne $T_C$ peuvent être présents à la fin de la durée de consigne $t_c$ du recuit de l'échantillon. Pour pouvoir prendre en compte ces écarts tardifs, la durée de consigne $t_c$' du recuit S3 doit être au moins aussi grande que la durée de la phase concernée par ces écarts de température.

La durée de consigne $t_c$' du recuit S3 peut varier en fonction de la forme et des dimensions de la pièce étalon (en particulier si celles-ci diffèrent de celles de l'échantillon), de la concentration en oxygène interstitiel du matériau semi-conducteur et du four utilisé pour réaliser les recuits. Par exemple, une durée $t_c$' faible peut être choisie lorsqu'on sait que le four est plutôt stable en température. Le procédé d'étalonnage gagne alors en temps d'exécution.

Sans indictions particulières, la durée de consigne $t_c$' choisie pour l'étalonnage sera avantageusement choisie entre 30 secondes et 2 heures. Cette plage constitue un bon compromis entre une durée suffisamment longue pour que la température dans le volume de la pièce étalon soit stabilisée (à la température de consigne) et une durée courte de sorte que la quantité de donneurs thermiques obtenue lors du palier de la pièce étalon ne soit pas prépondérante devant celle obtenue lors des phases de monté et de descente en température. Le rapport de la quantité de donneurs thermiques obtenue lors du palier sur la quantité de de donneurs thermiques obtenue lors des phases de monté et de descente en température est avantageusement inférieur à 10.

Dans certains fours de recuit et/ou pour certaines dimensions d'échantillons, la température $T_S$ de l'échantillon peut ne pas être stable pendant une durée importante lors du palier P2, à cause de problèmes de régulation de la température du four.

Par exemple, la température $T_S$ de l'échantillon peut dépasser la température de consigne $T_C$ en début de pallier P2, peu après la phase P1 de montée en température. Le procédé d'étalonnage permet de prendre en compte au moins en partie un tel dépassement (comme tout écart de température avec la température de consigne $T_C$ pendant la durée de consigne $t_c$'), et de façon complète si la durée de consigne $t_c$' du recuit S3 est supérieure ou égale à la durée du dépassement. Cependant, comme la durée du dépassement n'est pas connue, il ne peut être garanti que la durée de consigne $t_c$' choisie tiendra compte du dépassement dans son ensemble.

Pour y remédier, le procédé d'étalonnage (i.e. les étapes S1 à S5) peut être mis en oeuvre plusieurs fois avec une pluralité de pièces étalon, de préférence entre 4 et 10 fois. Les pièces étalon utilisées sont avantageusement identiques en tout point (matériau, forme et dimensions). Des valeurs différentes de durée de consigne $t_c$' sont choisies pour le recuit S3 des pièces étalon. Exceptée la durée de consigne, le recuit S3 est le même pour toutes les pièces étalon.

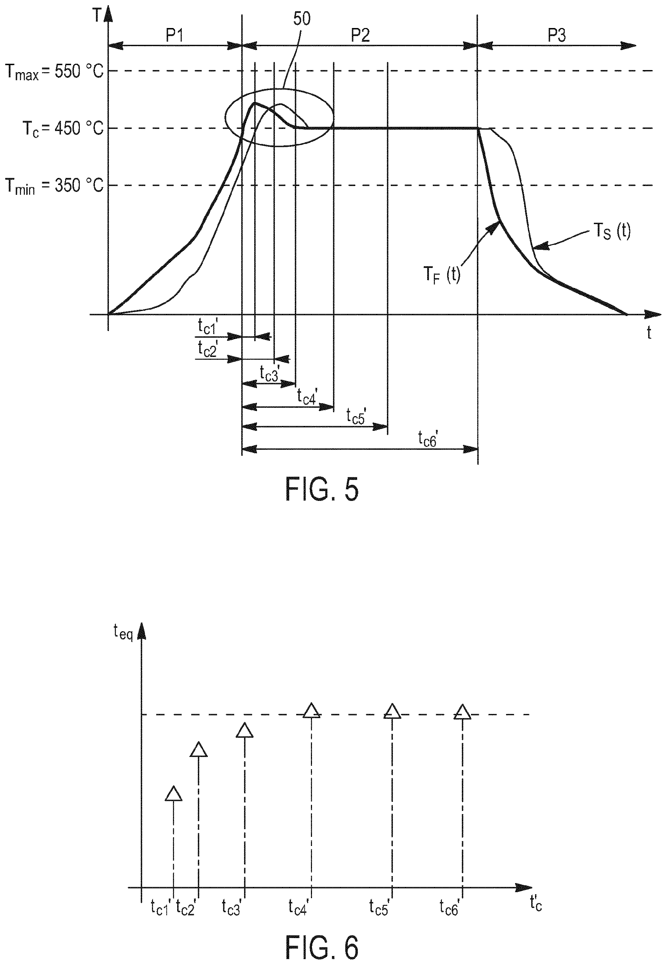

A titre d'exemple, la figure 5 représente en pallier du palier P2 une phase de dépassement 50 où la température $T_F$ du four et la température $T_S$ de l'échantillon dépasse la température de consigne $T_C$. Six valeurs différentes de durée de consigne, notée $t_{c1}$' à $t_{c6}$', sont choisies entre 30 s et 2 heures. Les valeurs $t_{c1}$' à $t_{c6}$' sont choisies de façon à couvrir une large gamme de durée, pour qu'au moins l'une d'elles soit supérieure à la durée du dépassement.

Il est alors obtenu une pluralité de valeurs de durée équivalente $t_{eq1}..t_{eq6}$, associées aux différentes pièces étalon et aux durées de consigne $t_{c1}$' à $t_{c6}$' correspondantes. Puis, lors d'une dernière étape, on détermine quelle est la durée de consigne minimale, au-delà de laquelle la durée équivalente $t_{eq}$ est constante. La détermination de la durée de consigne minimale peut être réalisée après avoir reporté sur un graphe les valeurs de durée équivalente obtenues, en fonction des valeurs correspondantes de durée de consigne.

La figure 6 est un graphe $t_{eq}(t_c')$ correspondant à l'exemple de la figure 5. On voit sur ce graphe que la durée équivalente $t_{eq}$ est indépendante de la durée de consigne $t_c$', à partir de $t_c$' = $t_{c4}$'. En effet, comme on le voit sur la figure 5, « $t_{c4}$' » est la plus faible des six valeurs de durée de consigne couvrant le dépassement dans son intégralité.

Ainsi, la détermination de la durée de consigne minimale garantit qu'un dépassement de température (et de façon plus générale, tout écart entre la température de consigne Tc et la température de l'échantillon) au début du palier est pris en compte dans son intégralité. La durée de consigne minimale peut être déterminée pour chaque four et/ou chaque taille d'échantillon.

On notera qu'il est préférable de déterminer la durée de consigne minimale avec des pièces étalon de dimensions importante, car le problème d'instabilité de la température est amplifié avec de telles pièces. La même durée de consigne minimale pourra alors être utilisée pour des pièces de plus petite taille.

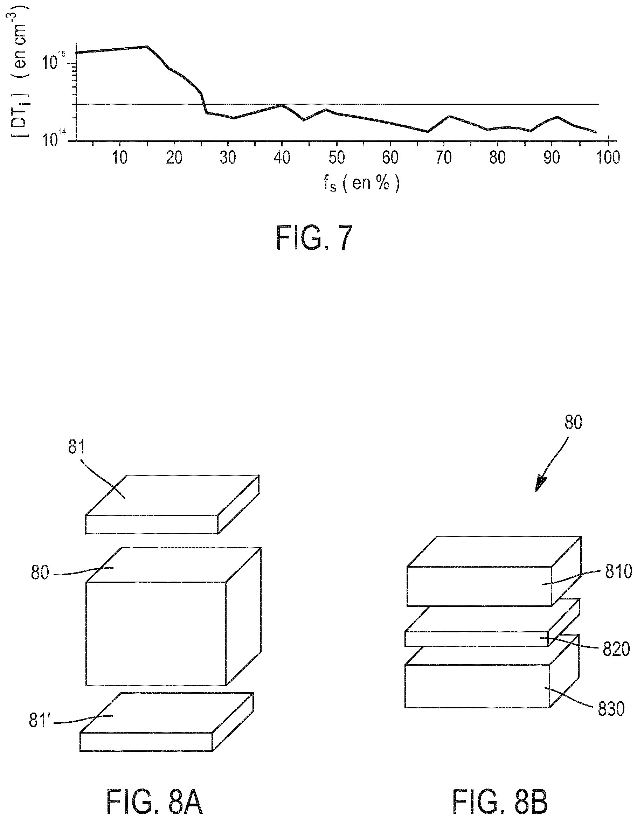

Comme indiqué précédemment, la pièce étalon peut être obtenue à partir d'un lingot de silicium Cz cristallisé à partir d'un bain de silicium intrinsèque. La figure 7 est un graphe représentant la concentration en donneurs thermiques initiaux $[DT_i]$, formés pendant la cristallisation d'un tel lingot, en fonction de la fraction solidifiée $f_s$ du lingot (exprimée en % de la longueur totale du lingot).

On remarque sur le graphe que la concentration en donneurs thermiques initiaux $[DT_i]$ du lingot diminue rapidement, pour ensuite se maintenir à un faible niveau. A partir d'une fraction solidifiée $f_s$ d'environ 25 %, toutes les valeurs de concentration $[DT_i]$ sont inférieures ou égales à $3.10^{14}$ cm$^{-3}$.

Cette zone de faible concentration $[DT_i]$ est considérée comme étant la portion du lingot solidifiée en dernier, appelée « pied du lingot ». Le pied de lingot contient moins de donneurs thermiques initiaux que la tête de lingot, i.e. la portion du lingot solidifiée en premier, car le pied de lingot est en contact thermique avec le silicium en fusion moins longtemps que la tête du lingot.

Lorsque la pièce étalon est obtenue à partir d'un lingot de silicium Cz, celle-ci est avantageusement découpée dans le pied de lingot (fs $\geq$ 25 %). On peut alors supposer alors que la concentration en donneurs thermiques initiaux [$DT_i$] est négligeable devant la concentration en donneurs thermiques [DT] formés lors du recuit S3. Cela permet de simplifier le procédé d'étalonnage en n'utilisant, à l'étape S4 de détermination de la concentration en donneurs thermiques [DT], plus qu'une seule valeur de la résistivité ou de la concentration en porteurs de charge libres. En effet, la concentration en porteurs de charge libres est alors supposée égale à deux fois la concentration en donneurs thermiques [DT].

Un exemple de mise en oeuvre du procédé d'étalonnage va maintenant être décrit en relation avec les figures 8A et 8B. Cet exemple concerne un échantillon de silicium Cz en forme de brique, de section carrée égale à 156x156 mm² et de 100 mm de hauteur. On souhaite soumettre cet échantillon à un recuit de formation de donneurs thermiques sous air, le recuit comprenant un palier à 450 °C. Le four de recuit utilisé chauffe au moyen de résistances métalliques. Afin d'éviter le risque de casse, la procédure de refroidissement suivante est appliquée :

- l'alimentation électrique des résistances métalliques est coupée après le palier à 450 °C et la porte du four reste fermée pendant 30 min ;
- après ouverture de la porte du four, la brique est laissée dans le four pendant deux heures ; puis
- la brique est retirée du four et laissée à température ambiante.

Une pièce étalon 80 (Fig.8A) est extraite d'un lingot en silicium Cz obtenu à partir d'une charge de silicium intrinsèque, de qualité électronique. Le diamètre du lingot est de 9 pouces. La pièce étalon 80 est sciée dans la portion du lingot solidifiée en dernier, située à une fraction $f_s$ supérieure à 50 %. La pièce étalon 80 a la même forme et les mêmes dimensions que l'échantillon (156 mm x 156 mm x 100 mm).

Deux plaquettes 81 et 81' sont également découpées dans le lingot, respectivement au-dessus et au-dessous de la pièce étalon 80. Ces plaquettes présentent des surfaces principales carrées (156x156 mm²) et une épaisseur d'environ 500 $\mu$m.

La concentration en oxygène interstitiel [Oi] est mesurée (étape S2) au centre d'une des faces principales de chaque plaquette 81, 81' grâce à la technique décrite dans le brevet FR2964459. La concentration [Oi] vaut $8,32 \times 10^{17}$ cm$^{-3}$ sur la plaquette supérieure 81 et $8,38 \times 10^{17}$ cm$^{-3}$ sur la plaquette inférieure 81'. La résistivité électrique est également mesurée au centre des plaquettes 81 et 81'. Elle est égale à 38 $\Omega$.cm sur la plaquette supérieure 81 et 40 $\Omega$.cm sur la plaquette inférieure 81'. Il est fait l'hypothèse que les valeurs de la concentration [Oi] et de la résistivité dans la pièce étalon 80 sont égales à la moyenne des valeurs mesurées sur les deux plaquettes 81 et 81'.

Ensuite, la pièce étalon 80 subit un recuit dans le même four, avec un palier de température à 450 °C pendant une durée de consigne égale à 30 min (étape S3). La même procédure de refroidissement est utilisée.

A l'issue du recuit, la pièce étalon est sciée en trois parties 810, 820 et 830 (Fig.8B). La partie prélevée au centre de la pièce étalon 80 est une plaquette 820, carrée, d'épaisseur égale à 500 $\mu$m environ. La résistivité après recuit est mesurée au centre d'une des faces principales de cette plaquette 820.

La concentration en donneurs thermiques [DT] formés dans la pièce étalon 80 lors du recuit est calculée à partir de la valeur moyenne de résistivité avant recuit et de la valeur de résistivité mesurée après recuit sur la plaquette 83. Elle vaut dans cet exemple $9,05.10^{13}$ cm$^{-3}$.

Enfin, la durée $t_{eq}$ de recuit à 450 °C, équivalente aux phases de chauffe et de refroidissement du four, ainsi que tout écart de la température de l'échantillon par rapport à 450 °C, est calculée à l'aide de la relation (2), connaissant la concentration en donneurs thermiques [DT] et la concentration en oxygène interstitiel [Oi]. Elle vaut dans cet exemple 12 minutes.

De nombreuses variantes et modifications du procédé d'étalonnage apparaîtront à l'homme du métier. En particulier, le procédé d'étalonnage peut comporter, avant la première mesure de résistivité (ou de la concentration en porteurs de charge libres), une étape dans laquelle la pièce étalon est soumise à un recuit à une température supérieure ou égale à 600 °C. Ce recuit à 600°C ou plus supprime les donneurs thermiques formés lors de la cristallisation du lingot. La valeur initiale de résistivité (avant le recuit S3) est alors plus élevée, ce qui permet d'affiner le calcul de la concentration en donneurs thermiques formés au cours du recuit S3. Un recuit à une température supérieure ou égale à 600 °C peut également être réalisé à la fin du procédé d'étalonnage pour détruire les donneurs thermiques formés lors du recuit S3. Il est avantageusement suivi d'une mesure de résistivité (ou de la concentration en porteurs de charge libres) dans le but d'améliorer la précision des calculs.

Enfin, bien que le procédé d'étalonnage ait été décrit en relation avec des échantillons et pièces étalon en silicium, il pourrait être appliqué à d'autres matériaux semi-conducteurs, par exemple le germanium ou l'alliage silicium-germanium. Le germanium est un candidat potentiel, car des donneurs thermiques à base d'oxygène peuvent être également formés par recuit dans le germanium.

# EP 3 184 673 B1

## Revendications

1. Procédé d'étalonnage d'un four permettant de soumettre un échantillon de matériau semi-conducteur à un premier recuit de formation des donneurs thermiques, le premier recuit comprenant successivement une montée (P1) en température du four, un premier palier (P2) à une température de consigne ($T_C$) et une descente (P3) en température du four,
procédé comprenant les étapes suivantes :

   a) prévoir (S1) une pièce étalon (40, 80) constituée du matériau semi-conducteur ;
   b) déterminer (S2) la concentration en oxygène interstitiel de la pièce étalon ;
   c) soumettre (S3) la pièce étalon à un deuxième recuit de formation des donneurs thermiques dans le four, le deuxième recuit comprenant des montée et descente en température du four identiques à celles du premier recuit et un deuxième palier à la température de consigne ($T_C$) pendant une durée de consigne ($t_c'$);
   d) déterminer (S4) la concentration en donneurs thermiques formés dans la pièce étalon lors du deuxième recuit ;
   e) déterminer (S5) une durée équivalente ($t_{eq}$) de recuit à la température de consigne ($T_C$), correspondant au moins auxdites montée et descente en température du four, à partir de la concentration en oxygène interstitiel, de la concentration en donneurs thermiques de la pièce étalon et de la durée de consigne ($t_c'$).

2. Procédé selon la revendication 1, dans lequel la pièce étalon (40, 80) présente une géométrie et des dimensions identiques à celles de l'échantillon.

3. Procédé selon la revendication 2, dans lequel la durée de consigne ($t_c'$) est comprise entre 30 secondes et 2 heures.

4. Procédé selon l'une des revendications 1 et 2, dans lequel les étapes a)-e) sont mises en oeuvre pour une pluralité de pièces étalon ayant des valeurs différentes de durée de consigne ($t_c'$), d'où il résulte une pluralité de valeurs de durée équivalente ($t_{eq}$), et comprenant en outre une étape de détermination de la valeur de durée de consigne au-delà de laquelle la durée équivalente ($t_{eq}$) est indépendante de la durée de consigne ($t_c'$).

5. Procédé selon l'une quelconque des revendications 1 à 4, dans lequel la pièce étalon (40, 80) est découpée dans un lingot de matériau semi-conducteur cristallisé selon la méthode Czochralski.

6. Procédé selon la revendication 5, dans lequel la concentration en oxygène interstitiel de la pièce étalon (40) est déterminée en mesurant la concentration en oxygène interstitiel sur au moins une chute (41) issue de la découpe du lingot, ladite chute (41) étant adjacente à la pièce étalon (40) dans le lingot.

7. Procédé selon l'une des revendications 5 et 6, dans lequel la concentration en donneurs thermiques est déterminée à partir d'une première mesure de la résistivité électrique ou de la concentration en porteurs de charge libres, réalisée avant le deuxième recuit (S3) sur une première plaquette (81, 81') adjacente à la pièce étalon (80) dans le lingot, et d'une deuxième mesure de la résistivité électrique ou de la concentration en porteurs de charge libres, réalisée après le deuxième recuit (S3) sur une deuxième plaquette (820) prélevée dans la pièce étalon (80).

8. Procédé selon l'une quelconque des revendications 5 à 7, dans lequel le lingot de matériau semi-conducteur est obtenu à partir d'un bain de matériau semi-conducteur intrinsèque en fusion.

9. Procédé selon la revendication 8, dans lequel la pièce étalon (40, 80) est découpée dans une partie du lingot cristallisée en dernier.

## Patentansprüche

1. Eichungsverfahren eines Ofens, das die Unterziehung einer Halbleiter-Materialprobe einem ersten Formgebungsglühen der thermischen Donatoren erlaubt, wobei das erste Glühen nacheinander einen Anstieg (P1) der Temperatur des Ofens, eine erste Schwelle (P2) auf eine Solltemperatur (Tc) und ein Senken (P3) auf die Temperatur des Ofens umfasst, wobei das Verfahren die folgenden Schritte umfasst:

   a) Vorsehen (S1) eines Eichstücks (40, 80), das aus Halbleitermaterial gebildet ist;
   b) Bestimmen (S2) der Zwischenraum-Sauerstoffkonzentration des Eichstücks;
   c) Unterziehen (S3) des Eichstücks einem zweiten Formgebungsglühen der thermischen Donatoren in dem Ofen, wobei das zweite Glühen einen Anstieg und ein Senken der Temperatur des Ofens, die mit denen des ersten Glühens identisch sind, und eine zweite Schwelle auf der Solltemperatur (Tc) während einer Solldauer (tc') umfasst;

d) Bestimmen (S4) der Konzentration an thermischen Donatoren, die beim zweiten Glühen in dem Eichstück gebildet sind;

e) Bestimmen (S5) einer äquivalenten Dauer ($t_{eq}$) des Glühens bei der Solltemperatur (Tc), die wenigstens dem genannten Anstieg und Senken der Temperatur des Ofens ausgehend von der Zwischenraum-Sauerstoffkonzentration, der Konzentration an thermischen Donatoren des Eichstücks und der Solldauer (tc') entspricht.

2. Verfahren gemäß Anspruch 1, bei dem das Eichstück (40, 80) eine Geometrie und Abmessungen aufweist, die mit denen der Probe identisch sind.

3. Verfahren gemäß Anspruch 2, bei dem die Solldauer (tc') zwischen 30 Sekunden und 2 Stunden inbegriffen ist.

4. Verfahren gemäß einem der Ansprüche 1 und 2, bei dem die Schritte a) bis e) für eine Vielzahl von Eichstücken umgesetzt werden, die von der Solldauer (tc') unterschiedliche Werte aufweisen, aus denen eine Vielzahl von Werten mit einer äquivalenten Dauer ($t_{eq}$) resultiert, und umfassend darüber hinaus einen Bestimmungsschritt des Wertes der Solldauer, über den hinaus die äquivalente Dauer ($t_{eq}$) von der Solldauer (tc') unabhängig ist.

5. Verfahren gemäß irgendeinem der Ansprüche 1 bis 4, bei dem das Eichstück (40, 80) in einem Barren aus gemäß dem Verfahren Czochralski kristallisierten Halbleitermaterial ausgeschnitten ist.

6. Verfahren gemäß Anspruch 5, bei dem die Zwischenraum-Sauerstoffkonzentration des Eichstücks (40) per Messen der Zwischenraum-Sauerstoffkonzentration auf wenigstens einem aus dem Ausschneiden des Barrens stammenden Verschnittstück (41) bestimmt ist, wobei das genannte Verschnittstück (41) dem Eichstück (40) in dem Barren benachbart angeordnet ist.

7. Verfahren gemäß einem der Ansprüche 5 und 6, bei dem die Konzentration an thermischen Donatoren ausgehend von einer ersten Messung des spezifischen elektrischen Widerstandes oder der Konzentration an freien Lastenträgern, die vor dem zweiten Glühen (S3) auf einer ersten Platte (81, 81') realisiert ist, die dem Eichstück (80) in dem Barren benachbart angeordnet ist, und einer zweiten Messung des spezifischen elektrischen Widerstandes oder der Konzentration an freien Lastenträgern, die nach dem zweiten Glühen (S3) auf einer zweiten Platte (820) realisiert ist, die in dem Eichstück (80) entnommen wird, bestimmt ist.

8. Verfahren gemäß irgendeinem der Ansprüche 5 bis 7, bei dem der Barren aus Halbleitermaterial ausgehend von einem der Fusion intrinsischen Halbleitermaterial-Bad erhalten ist.

9. Verfahren gemäß Anspruch 8, bei dem das Eichstück (40, 80) in einem Teil des Barrens ausgeschnitten ist, der als Letzter kristallisiert ist.

**Claims**

1. Method for calibrating a furnace enabling a sample of semiconductor material to be subjected to a first thermal donor formation annealing, the first annealing successively comprising a rise (P1) in temperature of the furnace, a first plateau (P2) at a set temperature (Tc) and a drop (P3) in temperature of the furnace, the method comprising the following steps:

a) providing (S1) a calibration piece (40, 80) comprised of the semiconductor material;
b) determining (S2) the interstitial oxygen concentration of the calibration piece;
c) subjecting (S3) the calibration piece to a second thermal donor formation annealing in the furnace, the second annealing comprising rise and drop in temperature of the furnace identical to those of the first annealing and a second plateau at the set temperature (Tc) for a set time ($t_c$');
d) determining (S4) the concentration of thermal donors formed in the calibration piece during the second annealing;
e) determining (S5) an equivalent annealing time ($t_{eq}$) at the set temperature (Tc), corresponding at least to said rise and drop in temperature of the furnace, from the interstitial oxygen concentration, the thermal donor concentration of the calibration piece and the set time ($t_c$').

**2.** Method according to claim 1, wherein the calibration piece (40, 80) has a geometry and dimensions identical to those of the sample.

**3.** Method according to claim 2, wherein the set time ($t_c$') is comprised between 30 seconds and 2 hours.

**4.** Method according to one of claims 1 and 2, wherein steps a)-e) are carried out for a plurality of calibration pieces having different set time ($t_c$') values, resulting in a plurality of equivalent time ($t_{eq}$) values, and further comprising a step of determining the set time value above which the equivalent time ($t_{eq}$) is independent of the set time ($t_c$').

**5.** Method according to any of claims 1 to 4, wherein the calibration piece (40, 80) is cut from a semiconductor material ingot crystallised according to the Czochralski method.

**6.** Method according to claim 5, wherein the interstitial oxygen concentration of the calibration piece (40) is determined by measuring the interstitial oxygen concentration on at least one scrap (41) stemming from the cutting of the ingot, said scrap (41) being adjacent to the calibration piece (40) in the ingot.

**7.** Method according to one of claims 5 and 6, wherein the thermal donor concentration is determined from a first measurement of the electrical resistivity or the free charge carrier concentration, carried out before the second annealing (S3) on a first wafer (81, 81') adjacent to the calibration piece (80) in the ingot, and from a second measurement of the electrical resistivity or the free charge carrier concentration, carried out after the second annealing (S3) on a second wafer (820) taken from the calibration piece (80).

**8.** Method according to any of claims 5 to 7, wherein the semiconductor material ingot is obtained from a melt of intrinsic semiconductor material.

**9.** Method according to claim 8, wherein the calibration piece (40, 80) is cut from a part of the ingot crystallised last.

FIG. 1

FIG. 2

- S1 -

- S2 -

- S3 -

- S4 -

- S5 -

FIG. 3

FIG. 4

FIG. 5

FIG. 6

15

EP 3 184 673 B1

FIG. 7

FIG. 8A

FIG. 8B

16

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2964459

**Littérature non-brevet citée dans la description**

- **F. JAY et al.** High Quality Thermal Donor Doped Czochralski Silicon Ingot for Industrial Heterojunction Solar Cells. *EU PVSEC Proceedings,* 2015, 316-321
- **WIJARANAKULA C.A. et al.** Formation kinetics of oxygen thermal donors in silicon. *Appl. Phys. Lett.,* 1991, vol. 59 (13), 1608

- **LONDOS C.A. et al.** Effect of oxygen concentration on the kinetics of thermal donor formation in silicon at temperatures between 350 and 500 °C. *Appl. Phys. Lett.,* 1993, vol. 62 (13), 1525